# EUROPEAN PATENT APPLICATION

(11) **EP 2 416 378 A2**
(43) Date of publication of application: **08.02.2012**
(21) Application number: 10759039.0
(22) Date of filing: 31.03.2010
(51) Int. Cl.: H01L 31/042

(54) **SOLAR PHOTOVOLTAIC POWER GENERATION APPARATUS AND MANUFACTURING METHOD THEREOF**

(30) Priority: 31.03.2009 KR 20090027862
(71) Applicant: LG Innotek Co., Ltd, Seoul 150-721 (KR)
(72) Inventor: LEE, Dong Keun, Seoul 100-714 (KR)
(74) Representative: Bethenod, Marc
(86) International application number: PCT/KR2010/001990
(87) International publication number: WO 2010/114314

(57) **Abstract**

Disclosed is a solar cell apparatus. The solar cell apparatus includes a solar cell, and an anti-reflective layer having a plurality of pores on the solar cell. The refractive index of the anti-reflective layer is easily adjusted due to the pores, so that the solar cell apparatus represents the optimal anti-reflection efficiency.

## Description

### [Technical Field]

The embodiment relates to a solar cell apparatus and a method of fabricating the same.

### [Background Art]

Recently, as energy consumption has been increased, solar cells capable of converting solar energy into electric energy have been developed.

In particular, a CIGS solar cell, which is a PN hetero junction device having a substrate structure including a glass substrate, a metal back electrode layer, a P type CIGS light absorption layer, a high-resistance buffer layer, and an N type window layer, is extensively used.

In order to improve the performance of the solar cell, researches and studies have been carried out toward the enhancement of incident light efficiency.

### [Disclosure]

### [Technical Problem]

The embodiment provides a solar cell apparatus capable of increasing light efficiency and a method of fabricating the same.

### [Technical Solution]

According to the embodiment, a solar cell apparatus includes a solar cell, and an anti-reflective layer having a plurality of pores on the solar cell.

According to the embodiment, a solar cell apparatus includes a solar cell, and an anti-reflective layer on the solar cell. The anti-reflective layer includes a plurality of crystalline columns extending in a direction inclined with respect to a top surface of the solar cell.

According to the embodiment, a solar cell apparatus includes a solar cell, a first anti-reflective layer on the solar cell, and a second anti-reflective layer on the first anti-reflective layer. The first anti-reflective layer includes a plurality of first crystalline columns extending in a first direction inclined with respect to a top surface of the solar cell, and the second anti-reflective layer includes a plurality of second crystalline columns extending in a second direction inclined with respect to the top surface of the solar cell.

According to the embodiment, a method of fabricating a solar cell apparatus includes forming a solar cell on a support substrate, and forming an anti-reflective layer by spraying an anti-reflective material in a direction inclined with respect to a top surface of the solar cell.

### [Advantageous Effects]

The solar cell apparatus according to the embodiment includes an anti-reflective layer including pores. Accordingly, the refractive index of the anti-reflective layer can be easily adjusted. The light efficiency of the solar cell apparatus can be improved by minimizing the reflection of a light incident from air (e.g., refractive index n=1) into a protective substrate or a top electrode layer.

In particular, since the anti-reflective layer has a porous structure due to pores, the anti-reflective layer has a refractive index lower than that of a dense structure. Therefore, the anti-reflective layer can reduce the rapid change of refractive indexes between the air and the protective substrate or between the air and the top electrode layer.

In other words, the quantity of sunlight reflected to the outside of the solar cell is reduced, and the quantity of sunlight absorbed into the solar cell is increased, so that the efficiency of the solar cell can be improved.

In addition, a plurality of anti-reflective layers include the same material, and are grown at angles different from each other. Accordingly, the refractive indexes of the anti-reflective layers including the same materials are gradually changed, so that superior anti-reflection effects can be represented.

### [Description of Drawings]

FIGS. 1 to 6 are sectional views showing a method of fabricating a solar cell apparatus according to a first embodiment;

FIG. 2 is a sectional view showing a solar cell apparatus according to a second embodiment;

FIG. 8 is an enlarged sectional view showing an anti-reflective film of a solar cell apparatus according to a third embodiment;

FIGS. 9 to 10 are sectional views showing a solar cell apparatus according to a fourth embodiment;

FIG. 11 is a sectional view showing a solar cell apparatus according to a fifth embodiment;

FIG. 12 is a graph showing the transmissivity in experimental example #3 and experimental example #1;

FIGS. 13 and 16 are sectional and plan views showing a TiO₂ layer in experimental examples #1, #2, and #3, and comparative example #1; and

FIGS. 17 and 18 are sectional views showing an MgF₂ layer in experimental example #8 and comparative example #2.

### [Best Mode]

### [Mode for Invention]

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" over the other substrate, layer (or film), region, pad, or pattern, or one or more intervening layers may also be present. Such a position of the layer has been described with reference to the drawings. The thickness and size of each layer shown in the drawings may be exaggerated, omitted or schematically drawn for the purpose of convenience or clarity. In addition, the size of elements does not utterly reflect an actual size.

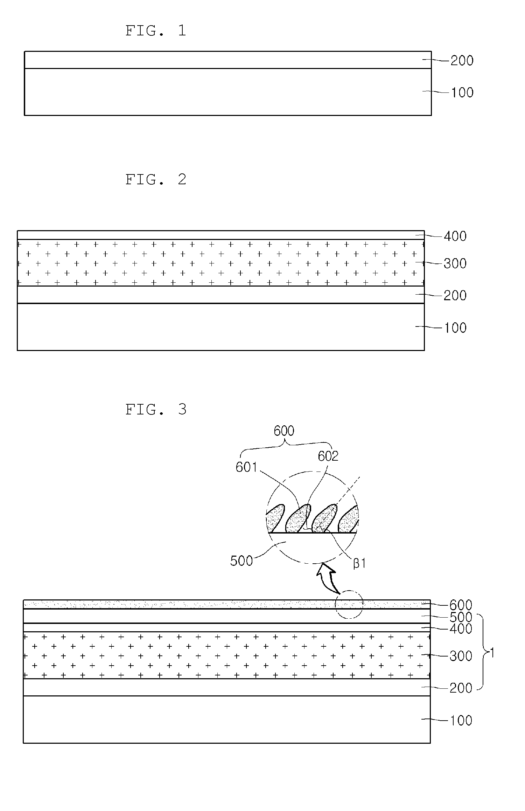

FIGS. 1 to 6 are sectional views showing a solar cell apparatus according to a first embodiment.

As shown in FIG. 1, a back electrode 200 is formed on a substrate 100.

The substrate 100 includes a glass, or may include one a ceramic substrate such as alumina, a stainless still substrate, a titanium substrate, or a polymer substrate. In more detail, the substrate 100 may include sodalime glass. In addition, the substrate 100 may have a rigid property or a flexible property.

The back electrode 200 may include a metallic conductor. For example, the back electrode 200 may be formed through a sputtering process employing a molybdenum (Mo) target.

The Mo target is used because Mo represents high conductivity, ohmic contact with a light absorption layer, and high-temperature stability under a Se atmosphere.

The Mo thin film constituting the back electrode 200 must have low resistivity as an electrode and must have a superior adhesion property with respect to the substrate 100 such that the back electrode 200 is not delaminated from the substrate 10 due to a thermal expansion coefficient difference with the substrate 10.

In addition, at least one back electrode 200 may be provided. When the back electrode 200 includes a plurality of layers 610, 620... and 600n, the layers 610, 620... and 600n constituting the back electrode 200 may include different materials.

Thereafter, as shown in FIG. 2, a light absorption layer 300 and a buffer layer 400 are formed on the back electrode 200. The light absorption layer 300 includes a Ib-IIb-VIb-based compound. In more detail, the light absorption layer 300 includes copper-indium-gallium-selenide (Cu(In, Ga) Se₂, CIGS)-based compound.

Differently, the light absorption layer 300 may include a copper-indium-selenide (CuInSe₂, CIS)-based compound or a cooper-gallium-selenide (CuGaSe₂, CIS)-based compound.

For example, in order to form the light absorption layer 300, a CIG-based metallic precursor layer is formed on the back electrode 200 by using a Co target, an In target, and a Ga target.

Thereafter, the metallic precursor layer reacts with Se through a selenization process to form the CIGS-based light absorption layer 300.

The light absorption layer 300 converts external incident light into electric energy. The light absorption layer 300 generates a photo-electromotive force based on a photo-electro effect.

At least one buffer layer 400 may be provided. For example, at least one buffer layer 400 may be formed by stacking a cadmium sulfide (CdS) layer.

In this case, the buffer layer 400 includes an N type semiconductor layer, and the light absorption layer 300 includes a P type semiconductor layer. Accordingly, the light absorption layer 300 and the buffer layer 400 construct a PN junction structure.

The buffer layer 400 may additionally include a zinc oxide (ZnO) layer formed on the CdS layer through a sputtering process using a ZnO target. The buffer layer 400 is interposed between the light absorption layer 300 and a top electrode layer 500 to be formed thereafter.

In other words, since the light absorption layer 300 and the top electrode layer 500 make a great difference in a lattice constant and an energy band gap, the buffer layer 400 having the intermediate energy band gap is interposed between the light absorption layer 300 and the top electrode layer 500, so that junction is smoothly made.

As shown in FIG. 3, the top electrode layer 500 and the anti-reflective film 600 are formed on the buffer layer 400.

The top electrode layer 500 may include a material selected from the group consisting of indium oxide (In₂O₃), zinc oxide (ZnO) and tin oxide (SnO₂). The top electrode layer 500 is a window layer forming PN junction together with the light absorption layer 300. Since the top electrode layer 500 serves as a transparent electrode on the entire surface of a solar cell 1, the top electrode layer 500 includes a material representing high light transmissivity and electric conductivity.

In this case, an electrode having low resistance may be formed by doping aluminum (Al) or alumina into a ZnO layer. In addition, an ITO (Indium thin oxide) layer may be additionally formed on the front-side layer 500.

Therefore, the solar cell 1 is formed on the substrate 100. In other words, the solar cell 1 includes the back electrode 200, the light absorption layer 300, the buffer layer 400, and the top electrode layer 500.

The anti-reflective film 600 may be formed on the solar cell 1 through an evaporation process or a sputtering process. In more detail, the anti-reflective film 600 may be formed on a top surface of the solar cell 1. In more detail, the anti-reflective film 600 may be coated on the top surface of the solar cell 1.

In this case, the anti-reflective film 600 may be formed under a vacuum state. In addition, a source material 20 for the anti-reflective film 600 is sprayed by a target or a source, and deposited on the top electrode layer 500, so that the anti-reflective film 600 is formed.

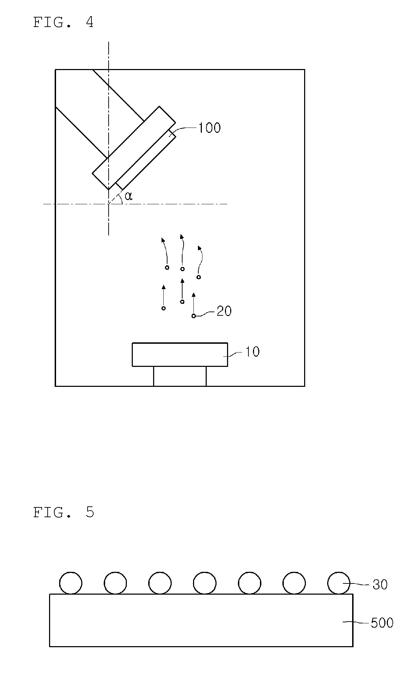

As shown in FIG. 4, the spray direction of the source material 20 is inclined with respect to the substrate 100. For example, the source material 20 may be sprayed in a direction inclined with respect to the substrate 100. In addition, the source material 20 may be sprayed onto the substrate 100 in a state that the substrate 100 is inclined.

For example, the source material 20 may be sprayed onto the substrate 100 in the stat that the substrate 100 is inclined at an angle of about 40° to about 80° with respect to a plane perpendicular to the spray direction of the source material 20. In other words, the source 10 may spray the source material 20 onto the substrate 100 in the state that the source 10 is inclined at an angle of about 40° to about 80° with respect to a direction perpendicular to the top surface of the top electrode layer 500.

In other words, the source 10 sprays the source material 20 used to form a first anti-reflective layer 610 in a direction inclined with respect to the top surface of the solar cell 1, that is, the top surface of the top electrode layer 500. In other words, on the assumption that the vertical direction refers to an angle of 0°, the source 10 sprays the source material 20 onto the substrate 100 at an angle α of about 40° to about 80°.

Therefore, as shown in FIGS. 3, 5, and 6, a plurality of crystalline columns 601 are grown in the direction inclined with respect to the top surface of the top electrode layer 500. In other words, the crystalline columns 601 extend in the direction inclined with respect to the top surface of the solar cell 1, that is, the top surface of the top electrode layer 500. In more detail, the crystalline columns 601 extend upward from the top surface of the top electrode layer 500. In other words, the crystalline columns 601 extend in the direction inclined with respect to the top electrode layer 500.

The crystalline columns 601 may form an angle β1 of about 10° to about 50° with respect to the top surface of the top electrode layer 500. As described above, as the crystalline columns 601 are formed, the anti-reflective film 600 is formed on the top electrode layer 500.

A plurality of pores 602 are formed between the crystalline columns 601. In other words, since the crystalline columns 601 are not densely formed on the top surface of the top electrode layer 500, the pores 602 are formed. The diameters or the widths of the pores 602 may be 1/20 to about 1/5 of the diameters or the widths of the crystalline columns 601.

The pores 602 may extend in the extension direction of the crystalline columns 601. Upper portions of the pores 602 may be open on the top surface of the anti-reflective film 600.

Therefore, the anti-reflective film 600 has a porous structure. In other words, the anti-reflective film 600 may not have a dense structure. In more detail, the anti-reflective film 600 may have a more porous structure and a less dense structure as the crystalline columns 601 are inclined.

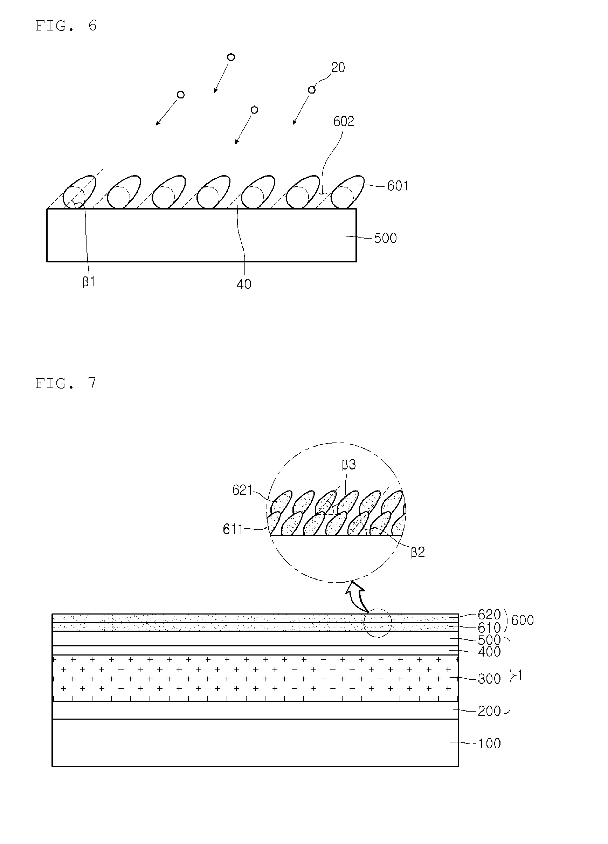

Referring to FIGS. 5 and 6, the method of forming the anti-reflective film 600 will be described in detail. In order to form the anti-reflective film 600, when a deposition process is performed, a core 30 is formed on the top electrode layer 500, and the source material 20 is deposited near the core 30, so that the crystalline columns 601 are grown.

In this case, the source material 20 is injected into the top electrode layer 500 at a predetermined angle, and the pores 602 are formed due to a shadow effect to generate a shadow area 40, so that the anti-reflective film 600 has a porous structure.

Since the anti-reflective film 600 has a porous structure, a refractive index is more reduced on the anti-reflective film 600 as compared with that of a thin film having a dens structure. Accordingly, the solar cell 1 can represent lower reflectance and improved transmissivity due to the anti-reflective film 600. In other words, the anti-reflective film 600 can increase anti-reflection efficiency.

For example, the anti-reflective film 600 may have a refractive index of about 1.18 to about 1.32. In more detail, the anti-reflective film 600 may have the refractive index of about 1.18 to about 1.29. In more detail, the anti-reflective film 600 may have a refractive index of about 1.18 to about 1.26.

The anti-reflective film 600 is transparent. The anti-reflective film 600 may include fluoride such as magnesium fluoride (e.g., MgF₂) and oxide such as indium tin oxide (ITO), silicon oxide (SiO₂), zinc oxide (ZnO) or titanium oxide (e.g., TiO₂).

The refractive index of the anti-reflective film 600 varies according to the spray angle of the source material 20. In other words, according to the method of fabricating a solar cell apparatus of the first embodiment, the anti-reflective film 600 may have a desired refractive index. In other words, the source material 20 is deposited on the top surface of the top electrode layer 500 at a desired angle, so that the anti-reflective film 600 may have the optimal refractive index to increase the quantity of light incident into the solar cell 1 as much as.

Therefore, the anti-reflective film 600 can reduce the rapid change between the air layer and the top electrode layer 500. Accordingly, the quantity of sunlight reflected by the top surface of the top electrode layer 500 can be reduced.

FIG. 7 is a sectional view showing a solar cell apparatus according to a second embodiment. In the following description about the present embodiment, the structures and components identical to those of the previous embodiments will not be further described except for the additional description about the anti-reflective film. The solar cell apparatus according to the second embodiment may be substantially identical to the solar cell apparatus according to the previous embodiment, except for several parts.

Referring to FIG. 7, the anti-reflective film 600 may include a plurality of layers 610, 620, ..., and 600n. In this case, crystalline columns may extend in different directions at the different layers 610, 620, ..., and 600n. For example, the angles β2 and β3 between the crystalline columns 601 and the top surface of the solar cell 1 vary according to the layers 610, 620, ..., and 600n. Accordingly, the layers 610, 620, ..., and 600n may have refractive indexes different from each other.

In this case, the processes of forming the layers 610, 620, ..., and 600n may be performed by spraying a source material on the top electrode layer 500 at angles different from each other. For example, the source material may be sprayed at a first angle to form the first layer. The source material may be sprayed at a second angle to form the second layer. The source material may be sprayed at a third angle to form the third layer.

For example, the anti-reflective film 600 may include the first and second anti-reflective layers 610 and 620.

The first anti-reflective layer 610 is formed on the solar cell 1. In more detail, the first anti-reflective layer 610 is formed on the top surface of the solar cell 1. In more detail, the first anti-reflective layer 610 is coated on the top surface of the solar cell 1.

The first anti-reflective layer 610 includes first crystalline columns 611. The first crystalline columns 611 extend in a first direction. In this case, the angle β2 between the first crystalline columns 611 and the top surface of the top electrode layer 500 may be in the range of about 10° to about 50°.

The second anti-reflective layer 620 is formed on the first anti-reflective layer 610. In more detail, the second anti-reflective layer 620 is formed on the top surface of the first anti-reflective layer 610. The second anti-reflective layer 620 is coated on the top surface of the first anti-reflective layer 610.

The second anti-reflective layer 620 includes a plurality of second crystalline columns 621. The second crystalline columns 621 extend in a second direction different from the first direction. In this case, the angle β3 between the second crystalline columns 621 and the top electrode layer 500 may be in the range of about 10° to about 50°.

In this case, the angle β2 between the first crystalline columns 611 and the top surface of the top electrode layer 500 may be different from the angle β3 between the second crystalline columns 621 and the top surface of the top electrode layer 500. For example, the angle β2 between the first crystalline columns 611 and the top surface of the top electrode layer 500 may be greater than the angle β3 between the second crystalline columns 621 and the top surface of the top electrode layer 500.

In addition, a third anti-reflective layer including a plurality of third crystalline columns extending in the third direction may be formed on the second anti-reflective layer 620. In addition, a fourth anti-reflective layer may be formed on the third anti-reflective layer.

Therefore, the above anti-reflective layers 610, 620, ..., and 600n may have refractive indexes different from each other. In addition, according to the present embodiment, the solar cell apparatus includes the anti-reflective film 600 including the anti-reflective layers 610, 620, ..., and 600n having the refractive indexes different from each other.

For example, the first anti-reflective layer 610 may have a higher refractive index, and the second anti-reflective layer 620 may have a lower refractive index. In addition, the third anti-refractive layer may have a refractive index lower than that of the second anti-reflective layer 620.

In addition, a higher layer among the anti-reflective layers 610, 620, ..., and 600n may have a lower refractive index. In contrast, the higher layer among the anti-reflective layers 610, 620, ..., and 600n may have a higher refractive index. In addition, each anti-reflective layer having a higher refractive index may be alternately aligned with an anti-reflective layer having a lower refractive index.

In particular, if the layers 610, 620... and 600n have the refractive index gradually lowered from the top surface of the solar cell 1 to the air layer, that is, if the refractive index of the layers 610, 620... and 600n is gradually reduced in the upward direction, the refractive index of the anti-reflective film is gradually reduced in the upward direction. Accordingly, the anti-reflective film 600 can effectively reduce the difference in the refractive indexes between the air and the top electrode layer 500.

The anti-reflective layers 610, 620, ..., and 600n of the anti-reflective film 600 may include the same material. In other words, the first anti-reflective layer 610, the second anti-reflective layer 620, and the third anti-reflective layer may include the same material.

As described above, the refractive indexes of the anti-reflective layers 610, 620, and ... 600n are set to desired values, respectively, so that the optimal anti-reflection effect can be realized. Therefore, the solar cell apparatus according to the present embodiment can represent improved generating efficiency.

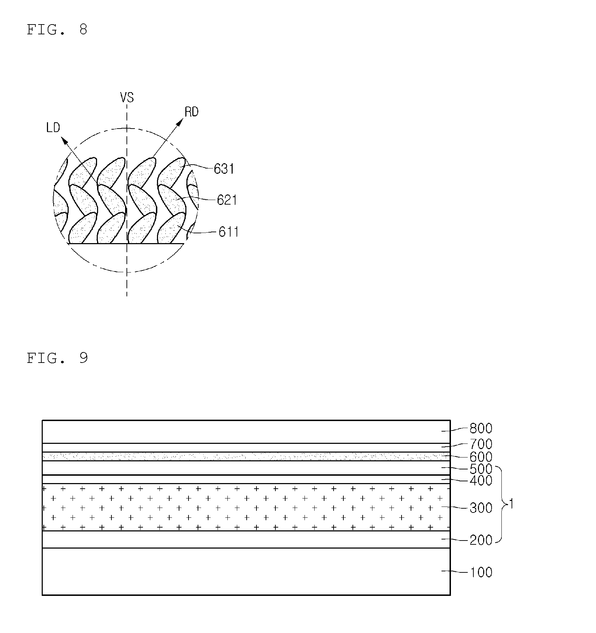

FIG. 8 is an enlarged sectional view showing an anti-reflective film of a solar cell apparatus according to a third embodiment.

In the following description about the present embodiment, the structures and components identical to those of the previous embodiments will not be further described except for the additional description for the anti-reflective film and modifications. The solar cell apparatus according to the third embodiment may be substantially identical to the solar cell apparatus according to the previous embodiment, except for several parts.

Referring to FIG. 8, crystalline columns 611, 621, and 631 of the anti-reflective layers may be formed in a zig-zag pattern. For example, the crystalline columns 611 of the first anti-reflective layer extend in one upward direction with respect to the plane VS perpendicular to the top surface of the solar cell 1, and the crystalline columns 621 of the second anti-reflective layer may extend in another upward direction of the perpendicular plane VS. In addition, the crystalline columns 631 may extend in the one upward direction.

For example, the first crystalline columns 611 may extend in a right upward direction RD on the basis of the perpendicular plane VS, and the second crystalline columns 621 may extend in a left upward direction LD with respect to the perpendicular plane VS. Similarly, the third crystalline columns 631 of the third anti-reflective layer may extend in the right upward direction RD of the perpendicular plane VS.

In this case, the crystalline columns 611, 621, and 631 of the anti-reflective layers may be inclined at the same angle or different angles with respect to the top surface of the solar cell 1. For example, the angle between the first crystalline columns 611 and the top surface of the solar cell 1 may be identical to or different from the angle between the second crystalline columns 621 and the top surface of the solar cell 1.

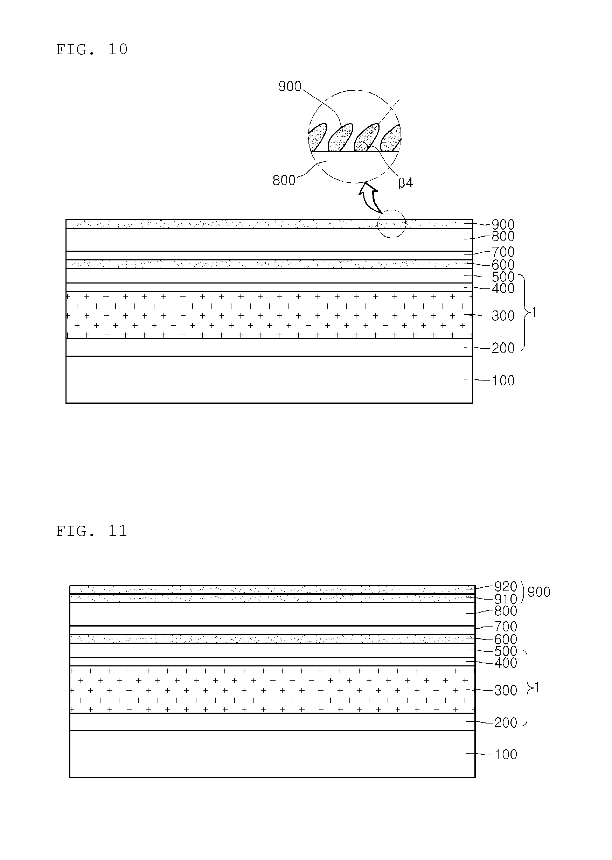

FIGS. 9 and 10 are sectional views showing an anti-reflective film of a solar cell apparatus according to a fourth embodiment. In the following description about the present embodiment, the structures and components identical to those of the previous embodiments will not be further described except for the additional description for an external anti-reflective film. The solar cell apparatus according to the fourth embodiment may be substantially identical to the solar cell apparatus according to the previous embodiment, except for several parts.

Referring to FIG. 9, a transparent resin 700 and a protective substrate 800 are formed on the anti-reflective film 600.

The transparent resin 700 may be formed through a thermal process using EVA (ethylene vinyl acetate copolymer), and the protective substrate 800 may include half-strengthened glass.

Thereafter, as shown in FIG. 10, an external anti-reflective film 900 is formed on the protective substrate 800. In more detail, the external anti-reflective film 900 is formed on the top surface of the protective substrate 900. In more detail, the external anti-reflective film 900 may be coated on the top surface of the protective substrate 900.

Similarly to the method of forming the anti-reflective film 600 according to the previous embodiments, the external anti-reflective film 900 may be formed through an evaporation process or a sputtering process.

Similarly, the external anti-reflective film 900 may have the same structure as that of the anti-reflective film 600 according to the previous embodiments. In other words, the external anti-reflective film 900 includes a plurality of crystalline columns 901 extending in a direction inclined with respect to the top surface of the protective substrate 800. The crystalline columns 901 extend upward from the top surface of the protective substrate 800.

For example, an angle β4 between the crystalline columns 901 and the top surface of the protective substrate 800 may be in the range of about 10° to about 50°.

Due to the external anti-reflective film 900, the quantity of sunlight reflected from the top surface of the protective substrate 800 can be reduced, and the transmissivity can be improved. In other words, the anti-reflection efficiency can be increased by the external anti-reflective film 900.

In addition, the external anti-reflective film 900 may be formed on a bottom surface of the protective substrate 800 as well as the top surface of the protective substrate 800.

FIG. 11 is a sectional view showing a solar cell apparatus according to a fifth embodiment. In the following description about the present embodiment, the structures and components identical to those of the previous embodiments will not be further described except for the additional description for an external anti-reflective film. The solar cell apparatus according to the fifth embodiment may be substantially identical to the solar cell apparatus according to the previous embodiment, except for several parts.

Referring to FIG. 11, the external anti-reflective film 900 may include a plurality of layers 910, 920, ... and 900n. In addition, the external anti-reflective film 900 may be formed similarly to a process of forming an anti-reflective film having a multiple layer structure according to the previous embodiments and have a structure similar to that of the anti-reflective film having a multiple layer structure.

Due to the external anti-reflective film 900, the quantity of sunlight reflected from the top surface of the protective substrate 800 can be reduced, and the transmissivity can be improved. In other words, the anti-reflection efficiency can be increased by the external anti-reflective film 900.

In particular, the layers 910, 920, ..., and 900n of the external anti-reflective film 900 may have desired refractive indexes. Therefore, the external anti-reflective film 900 can effectively reduce the difference in the refractive index between the air layer and the protective substrate 800.

Therefore, the solar cell apparatus according to the present embodiment can represent improved generating efficiency.

Although the exemplary embodiments of the present invention have been described, it is understood that the present invention should not be limited to these exemplary embodiments but various changes and modifications can be made by one ordinary skilled in the art within the spirit and scope of the present invention as hereinafter claimed.

Experimental Examples #1, #2, and #3, and Comparative Example #1

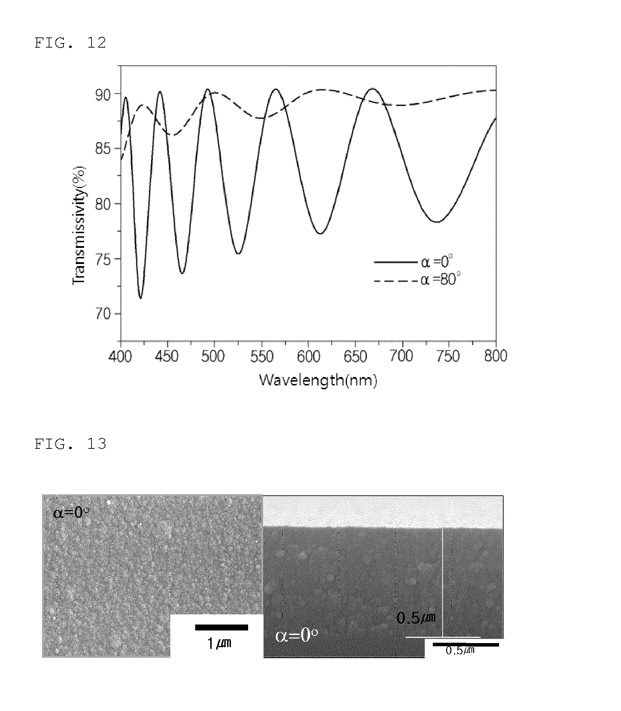

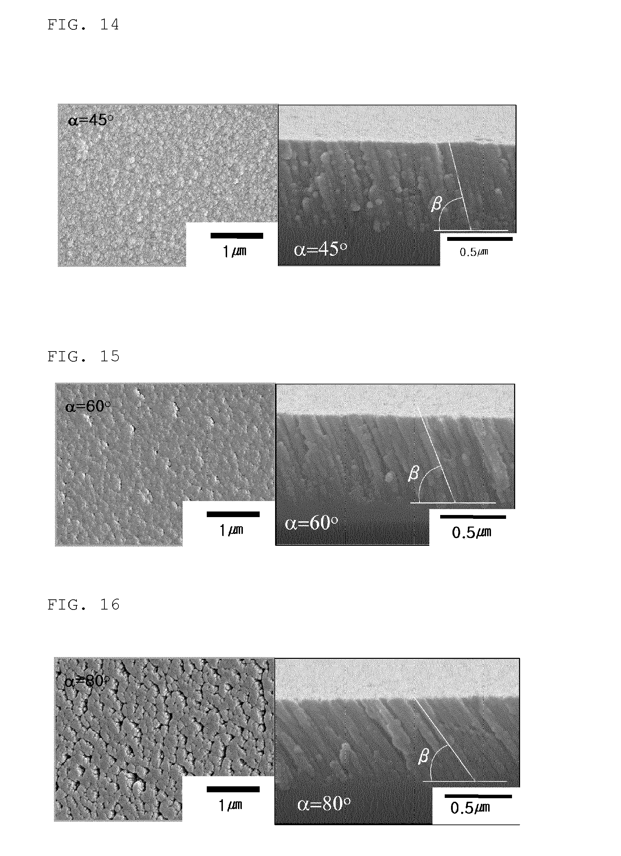

A sputtering process is performed to deposit TiO₂ on a glass substrate in an inclination direction and a vertical direction. In ex examples #1, #2, and #3, and comparative example #1, the glass substrate is inclined at an angle of about 45°, about 60°, about 80°, or 0° with respect to a plane perpendicular to the spray direction of TiO₂. The transmissivity in experimental example #3 and comparative example #1 is shown in FIG. 12. In addition, the sectional and plan views of the TiO₂ layer in experimental examples #1, #2, and #3 and comparative example #1 are shown in FIGS. 13 to 16.

Experimental Examples #4, #5, #6, #7, and #8, and Comparative Example #2

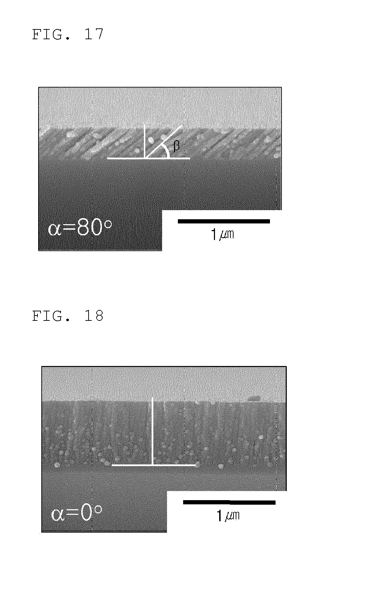

A sputtering process is performed to deposit MgF₂ on a glass substrate at a predetermined thickness in an inclination direction and a vertical direction. In Experimental Examples #4, #5, #6, #7, and #8, and Comparative example #2, inclination angles α of the glass substrate with respect to a plane perpendicular to the spray direction of MgF₂ and the refractive indexes of MgF₂ layer according to the inclination angles α are shown in table 1. The sectional shapes of the MgF₂ layer according to Experimental Example #8 and Comparative Example #2 are shown in FIGS. 17 and 18. As shown in Table 1, the refractive index of the MgF₂ layer may be set to various values according to the inclination angles.

**Table 1**

| | Inclination Angle of Glass Substrate | Refractive index of MgF₂ layer |
|---|---|---|
| Experimental Example #4 | 20 | 1.373 |
| Experimental Example #5 | 40 | 1.363 |
| Experimental Example #6 | 60 | 1.327 |
| Experimental Example #7 | 70 | 1.266 |
| Experimental Example #8 | 80 | 1.191 |
| Comparative Example #2 | 0 | 1.376 |

### [Industrial Applicability]

The embodiment is applicable to a solar cell apparatus.

## Claims

1. A solar cell apparatus comprising:
a solar cell; and
an anti-reflective layer having a plurality of pores on the solar cell.

2. The solar cell apparatus of claim 1, wherein the anti-reflective layer has a refractive index in a range of about 1.18 to about 1.29.

3. The solar cell apparatus of claim 1, wherein the anti-reflective layer includes a plurality of crystalline columns extending in a direction inclined with respect to a top surface of the solar cell, and the pores are interposed between crystalline columns.

4. The solar cell apparatus of claim 1, further comprising a transparent protective substrate interposed between the anti-reflective layer and the solar cell, wherein the anti-reflective layer is coated on a top surface of the protective substrate.

5. The solar cell apparatus of claim 1, wherein the solar cell includes:
a back electrode;
a light absorption layer on the back electrode; and
a top electrode layer on the light absorption layer, wherein the anti-reflective layer is coated on the top electrode layer.

6. The solar cell apparatus of claim 3, wherein each pore has a width in a range of about 1/20 to about 1/5 of a width of each crystalline column.

7. A solar cell apparatus comprising:
a solar cell; and
an anti-reflective layer on the solar cell,
wherein the anti-reflective layer includes a plurality of crystalline columns extending in a direction inclined with respect to a top surface of the solar cell.

8. The solar cell apparatus of claim 7, wherein the crystalline columns are inclined at an angle of about 10° to about 50° with respect to the top surface of the solar cell.

9. The solar cell apparatus of claim 7, wherein the anti-reflective layer includes titanium oxide or magnesium fluoride.

10. The solar cell apparatus of claim 7, wherein the solar cell includes:
a back electrode layer;
a light absorption layer on the back electrode layer;
and
a top electrode layer on the light absorption layer, wherein the crystalline columns extend from a top surface of the top electrode layer.

11. The solar cell apparatus of claim 7, further comprising a transparent protective substrate interposed between the anti-reflective layer and the solar cell, wherein the crystalline columns extend from a top surface of the protective substrate.

12. A solar cell apparatus comprising:
a solar cell;
a first anti-reflective layer on the solar cell; and
a second anti-reflective layer on the first anti-reflective layer,
wherein the first anti-reflective layer includes a plurality of first crystalline columns extending in a first direction inclined with respect to a top surface of the solar cell, and the second anti-reflective layer includes a plurality of second crystalline columns extending in a second direction inclined with respect to the top surface of the solar cell.

13. The solar cell apparatus of claim 12, wherein the first and second anti-reflective layers include materials identical to each other and have refractive indexes different from each other.

14. The solar cell apparatus of claim 12, wherein a second angle between the second crystalline columns and the top surface of the solar cell is less than a first angle between the first crystalline columns and the top surface of the solar cell.

15. The solar cell apparatus of claim 14, further comprising a third anti-reflective layer on the second anti-reflective layer, wherein the third anti-reflective layer includes a plurality of third crystalline columns extending in a third direction inclined with respect to the top surface of the solar cell, and an angle between the third crystalline columns and the top surface of the solar cell is less than the second angle between the second crystalline columns and the top surface of the solar cell.

16. The solar cell apparatus of claim 12, wherein the first direction is inclined in one direction with respect to a plane perpendicular to the top surface of the solar cell, and the second direction is inclined in an opposite direction of the perpendicular plane.

17. The solar cell apparatus of claim 16, further comprising a third anti-reflective layer on the second anti-reflective layer,
wherein the third anti-reflective layer includes a plurality of third crystalline columns inclined in a third direction with respect to the top surface of the solar cell, and the third direction is inclined in one direction with respect to the perpendicular plane differently from the second direction.

18. A method of fabricating a solar cell apparatus, the method comprising:
forming a solar cell on a support substrate; and
forming an anti-reflective layer by spraying an anti-reflective material in a direction inclined with respect to a top surface of the solar cell.

19. The method of claim 18, wherein the anti-reflective material is sprayed at an angle of about 70° to about 80° with respect to a normal line to the top surface of the solar cell.
